# EUROPEAN PATENT APPLICATION

(11) **EP 4 787 711 A1**
(43) Date of publication of application: **05.08.2026**
(21) Application number: 26153480.4
(22) Date of filing: 22.01.2026
(51) Int. Cl.: H03K 17/96, H03K 17/955

(54) **CONTROLLING SWITCH FOR RESIDENTIAL ELECTRICAL INSTALLATIONS**

(30) Priority: 31.01.2025 BE 202505063
(71) Applicant: Niko, 9100 Sint-Niklaas (BE)
(72) Inventor: DESMET, Arne, 9100 Sint-Niklaas (BE); VELDEMAN, Pol, 9100 Sint-Niklaas (BE)
(74) Representative: Calysta NV

(57) **Abstract**

A controlling switch for controlling a state of an electrical circuit comprising a housing enclosing modules comprising an input module to receive electrical power, a user interface module comprising a surface panel comprising a light-emitting assembly to the surface panel, capacitive touch areas to receive an input command, an output module to control the state of the electrical circuit based on the input command, a proximity sensing module to emit detection signals and receive reflected signals for detecting a presence of a user, wherein the surface panel and the proximity sensing module are positioned in different planes of the housing.

## Description

### Technical Field

The present invention relates to the field of electrical installations, specifically to electrical switches, more specifically to controlling switches for residential electrical installations, which incorporate user interfaces, proximity sensing capabilities, and advanced control features for managing electrical circuits.

### Prior art

Conventional electrical switches in residential installations primarily serve as basic mechanisms to open or close electrical circuits. Recent advances in smart home technology and user interface designs have created demand for switches with enhanced functionality, including user-friendly interfaces, proximity sensing capabilities, and adaptive illumination. However, existing solutions often fail to integrate these features effectively while maintaining compatibility with traditional enclosures and power sources.

EP1672796A2 describes an electrical switch comprising light emitters and receivers for detecting objects within a predefined range. The device operates by emitting modulated light, which is reflected by an object and detected by the receiver to determine the object's presence. A control device is coupled to a remote detecting device, for controlling and actuating the electric appliance, when the light emitting and receiving device has detected that a user is going toward or close to the housing of the switch device.

FR3030945A1 relates to a non-contact domestic electric switch designed to control electrical circuits without requiring physical interaction. The switch operates using a detection system that identifies the presence or movement of a user or an object within a defined detection zone. The document describes the configuration of the detection system, which may include optical or capacitive sensors, and its integration into the switch housing. The non-contact design allows the switch to be activated or deactivated without direct physical contact, making it suitable for domestic use in controlling lighting, appliances, or other electrical systems.

US9389769B1 describes an electronic device housing with integrated proximity sensors and light-emitting elements. The proximity sensors are configured to detect the presence or movement of an object near the device, while the light-emitting elements provide illumination or visual feedback.

US20240249606A1 describes an interactive light switch accessory apparatus. The apparatus includes an electronic plate device designed to function as a cover plate or attachment for one or more light switches. It features a computing module, one or more sensors to collect environmental information (e.g., temperature, humidity, and air quality), light-emitting elements, and a display module to communicate information to users. The device integrates sensors and communication modules to gather and display localized and targeted information.

DE202019003701U1 describes a switching element featuring a distance-measuring sensor element for contactless detection of user interactions, independent of ambient light conditions. The switching element comprises at least one operating element, a control unit, and a proximity sensor coupled to the control unit. The sensor detects the approach of a user, such as a finger or hand, to the operating element. Upon detection, the control unit provides information related to the operation of the element via a connected display unit before activation.

Conventional switch designs suffer from several limitations that hinder their practicality and adaptability. Their lack of design flexibility often results in bulky or standardized layouts that cannot accommodate compact or customized configurations, restricting their use in modern, space-efficient environments. Additionally, improper display activation within the detection zone leads to frequent instances of glare and visual distractions, reducing overall usability and comfort. For example, in many cases, the display of such switches illuminates whenever a person walks past or comes near, regardless of whether interaction is intended. This illumination often spills into the surrounding space, creating an unwelcome disruption for individuals present in the area. Together, these shortcomings not only compromise the functionality and visual appeal of the switches but also make them ill-suited for diverse applications requiring a combination of aesthetics, user comfort, and adaptability to various environments and use cases.

### Brief summary of the invention

The objective of the present invention is to provide a controlling switch that overcomes the drawbacks of conventional designs by incorporating intelligent detection and activation mechanisms to enhance energy efficiency and user comfort. The switch activates its display in a direction only when a user is actively interacting with or intending to use it, thereby eliminating unnecessary illumination and preventing glare or distractions in the surrounding space.

According to the invention, this objective is solved by the controlling switch according to the first claim configured to be installed within an enclosure of a vertical wall surface of a residential electrical installation for controlling a state of an electrical circuit thereof, the controlling switch comprising a housing enclosing operatively coupled modules through a processing unit comprising:
- an input module configured to receive electrical power from an external power source;
- a user interface module comprising:
   ∘ a surface panel comprising a light-emitting assembly configured to illuminate at least a portion of the surface panel for displaying input information;
   ∘ a set of capacitive touch areas configured to receive an input command related to the input information;
- an output module configured to control the state of the electrical circuit based on the input command;
- a proximity sensing module configured to emit detection signals and receive reflected signals for detecting a presence of a user;
wherein the user interface module and the proximity sensing module are positioned in different planes of the housing such that the detection signals are emitted according to a first direction, and the light-emitting assembly emits light according to a second direction different from the first direction.

A residential electrical installation typically refers to the electrical systems designed for private homes, including wiring, outlets, lighting, and appliances tailored to domestic use. However, this designation does not inherently exclude similar installations in commercial environments such as stores and offices. Many features of residential systems, such as standard voltage ranges, circuit breakers, and user-operated switches, are equally applicable to smaller-scale commercial settings. For instance, an electrical installation in a retail store or office may share core functionalities with residential setups, including lighting control, device connectivity, and safety mechanisms, while accommodating higher usage demands or specific layout requirements. This overlap underscores the versatility of such systems, highlighting that the term "residential electrical installation" should be interpreted broadly to encompass applications in environments with similar structural and operational characteristics, beyond purely domestic use.

A vertical wall surface and an enclosure within such a wall are common references when describing the placement of switches in residential or commercial installations. It should however be understood that this also includes other surfaces where switches can be mounted, such as desk surfaces, furniture panels, ceiling structures, or freestanding enclosures. These surfaces provide the necessary support and space for securely housing the switch and its components, ensuring proper functionality and safety. An enclosure within these surfaces serves the purpose of protecting the electrical components while maintaining accessibility for operation or maintenance. Whether mounted on a wall or another type of surface, the placement ensures that the switch remains functional and integrated into the overall design of the installation. Although the switch is designed to be installed within an enclosure on a vertical wall surface, this should not be interpreted as a limitation of the invention. The configuration allows for installation in various types of surfaces beyond vertical walls, including horizontal or inclined surfaces such as desks, countertops, ceilings, or custom-built panels.

The controlling switch further comprises a housing comprising operatively coupled modules as will be further discussed. The housing may further comprise a decorative cover to protect the sensing module while maintaining signal transmission efficiency. This dual-purpose design enhances both the functionality and aesthetics of the switch. The decorative cover shields the sensitive components of the sensing module from environmental factors such as dust, moisture, and physical damage, thereby improving durability and extending the lifespan of the device. At the same time, it is engineered to allow unhindered transmission and reception of signals, ensuring that the sensing module operates accurately and reliably. This feature enables the housing to maintain the switch's sleek, modern appearance without compromising its performance. Moreover, the decorative cover can be customized in terms of materials, textures, and colours, allowing it to blend seamlessly into various interior designs while still performing its protective and functional roles effectively.

The controlling switch is a device configured to control the state of an electrical circuit within a residential electrical installation, such as activating or deactivating power flow to connected electrical devices or systems. Its functionality may extend beyond traditional on/off capabilities to include features such as dimming, scene setting, or time-based control. The controlling switch is thus suitable for various applications, including lighting systems, home appliances, and climate control devices, such as opening and closing shutters and/or screens. To this end, the controlling switch comprises an output module configured to switch the state of the electrical circuit into a closed and opened position. Additionally, or alternatively, the output module is further configured to selectively adjust the characteristic of electrical current flowing in the electrical circuit when active such as voltage, current intensity, frequency, and/or waveform shape. The controlling switch may further interact with an energy management system that enables optimization of energy use by activating or deactivating circuits based on real-time data like load demand or schedules. This integration supports dynamic monitoring, prioritizes renewable energy, reduces costs, and enhances grid efficiency.

The output module may further be equipped with a wireless communication module designed to control the state of a connected device in response to an input command. This feature significantly enhances the versatility and functionality of the switch by enabling seamless integration with wireless networks and smart home ecosystems. The wireless communication module allows the switch to interact with devices over protocols such as Wi-Fi, Bluetooth, Zigbee, or other loT standards, facilitating remote control, automation, and synchronization with other systems. This configuration eliminates the need for physical wiring between the switch and the connected device, offering greater flexibility in installation and scalability. Furthermore, it enables advanced features such as real-time monitoring, programmable schedules, and integration with voice-activated assistants. By incorporating wireless control capabilities, the switch provides a modern, efficient solution for managing connected devices in residential, and/or commercial environments, aligning with the growing demand for smart, connected technologies.

The processing unit is a central feature of the controlling switch, configured operatively connecting the different modules. It serves as the central component of the controlling switch, functioning as the core hub that seamlessly integrates and operatively connects the various modules within the system. By managing communication and coordination between components such as the user interface, proximity sensing module, the processing unit ensures a smooth and efficient operation of the switch. It acts as the command centre, processing input data from the modules, analysing conditions such as user presence or movement, and executing corresponding actions, such as activating or deactivating specific features. This central role not only enhances the overall functionality and reliability of the switch but also provides the flexibility to adapt to diverse applications and user requirements. Additionally, the processing unit's capability to manage real-time interactions and system responses contributes to a cohesive and intelligent operational framework, making the switch highly adaptable, and efficient. It may further be configured to analyse received reflected signals and extract critical information such as the presence, distance, and movement of a user by detecting variations in these signals. This sophisticated signal analysis enables the switch to dynamically adapt its behaviour based on real-time conditions, ensuring that the user interface responds intelligently to the surrounding environment. For instance, when the processing unit detects a user approaching, it can instruct the user interface module to illuminate the surface panel, providing a clear and immediate indication that the switch is ready for interaction. This functionality not only enhances user convenience and interaction efficiency but also improves energy efficiency by activating the illumination only when relevant conditions are met. By combining advanced detection capabilities with a responsive interface, this configuration ensures a highly intuitive and user-friendly experience while maintaining practicality and energy-conscious operation.

The input module is configured to receive electrical power from an external power source, for example the power source associated with the electrical circuit. Alternatively, the power source may consist of a set of batteries.

The user interface module is designed to provide a seamless and intuitive method for user interaction by combining a set of capacitive touch areas and a surface panel with integrated illumination. The surface panel incorporates a light-emitting assembly configured to illuminate specific areas of the panel, allowing it to display input information. This illumination enhances visibility, improves usability in low-light conditions, and serves as feedback to indicate the device's operational status or confirm input commands. By utilizing energy-efficient technologies such as LEDs, the light-emitting assembly offers customizable lighting effects, including colour changes, brightness adjustments, and pulsating patterns, further enhancing the interface's aesthetic appeal and functionality.

The set of capacitive touch areas is designed to detect and interpret a user's touch input, capturing details such as location, duration, and intensity. The integrated set of capacitive touch areas allows users to interact intuitively with the switch by providing input commands related to the displayed information. These touch-sensitive areas enable a wide range of interactions, from simple taps to complex gestures like swipes or pressure-sensitive actions, enhancing the precision and versatility of the interface. Together, these features create a modern, user-friendly interaction method that is well-suited for standalone devices and smart system integrations, ensuring clear and effective communication between the user and the system across diverse environments.

The proximity sensing module is designed to detect the presence of a user by emitting detection signals and analysing the reflected signals that return from nearby objects and/or persons. This module employs technologies such as infrared, ultrasonic, radar technology, or capacitive sensing to enable non-contact detection. The proximity sensing module comprises an infrared emitter and detector for detecting the presence of a user based on reflected infrared light, or an ultrasonic transducer configured to detect objects based on sound wave reflections, or other technologies suitable for detecting a presence of a user.

According to a new and innovative aspect of the invention, the surface panel and the proximity sensing module are positioned in different planes of the housing such that the detection signals are emitted in a first direction, and the light-emitting assembly emits light in a second direction different from the first direction.

By displaying information on the surface panel in a direction different from the one in which the user's presence is detected, a clear and functional separation between detection and display is achieved, enhancing both the user experience and the overall system functionality. This separation ensures that information is clearly visible from a convenient angle while the proximity sensor operates discreetly, minimizing false activations by restricting the detection zone to intentional interactions. The switch can be elegantly and aesthetically integrated into the wall, blending seamlessly into modern or bespoke interiors with its technical functions discreetly concealed, all without compromising accessibility or usability.

Its modular design further allows for flexible customization, enabling compact and aesthetically pleasing layouts that can be tailored to various environments, from residential to commercial settings. The switch delivers a superior combination of functionality, usability, and visual appeal, making it adaptable to diverse applications and user preferences.

The design and arrangement of the capacitive touch areas play a crucial role in enhancing the functionality and usability of the controlling switch. According to an embodiment, the set of capacitive touch areas is positioned along the first direction. This specific orientation ensures that the touch-sensitive interface aligns with the user's natural interaction angle, improving accessibility and ergonomics. By strategically placing the touch areas in relation to the display and detection zones, the switch provides an intuitive user interface that complements the functional separation between detection and display. This arrangement not only enhances the precision of user input but also supports seamless integration into diverse environments.

When the controlling switch is mounted within the enclosure, the first direction comprises a first spatial direction substantially perpendicular to and away from the wall surface, and the second direction comprises a second spatial direction substantially parallel to and upwards along the wall surface.

This approach also optimizes energy efficiency by activating the display only when a user is present and provides significant design flexibility, enabling compact and customized layouts while reducing glare and distractions in the detection zone. These features make the switch both visually appealing and practical, suitable for various environments and styles, and adaptable for use in both personal and multi-user settings. These combined advantages enhance functionality, usability, and design versatility, delivering a superior interaction experience.

According to an embodiment, the controlling switch further comprises an indicator module comprising indicator means configured to signal the presence of a user, the indicator module positioned at the front plane when mounted within the enclosure.

The controlling switch is enhanced with an indicator module that includes indicator means configured to signal the presence of a user, providing a visual or sensory cue to improve user awareness and interaction. By positioning the indicator module on the front plane when mounted within the enclosure, the design ensures that the signalling mechanism is both prominent and easily perceivable, regardless of the surrounding environment. This placement enhances the functional visibility of the switch, making it particularly useful in low-light or high-traffic areas. This optional embodiment not only increases the switch's utility and usability but also adds to its aesthetic value, as the front-plane positioning allows seamless integration into modern and stylish designs. To this end, the processing unit is configured to instruct the indicator module to signal the presence of a user based on the condition. Furthermore, it may further be configured to first instruct the indicator module to signal the presence of a user prior to instruct the user interface module to illuminate the surface panel based on the condition during a predefined time interval. Moreover, it may also be configured in such a way that only the indicator module to signal the presence of a user, and that the surface panel is not illuminated at all. This can be the case when a user is walking away from the controlling switch.

According to a second aspect of the invention, a controlling switch assembly is disclosed comprising a housing comprising two or more controlling switches according to the first aspect of the invention.

The two or more controlling switches of the controlling switch assembly are, according to an embodiment, configured to share their respective set of capacitive touch areas. Furthermore, according to another embodiment, the two or more controlling switches are further configured to share their input module, and/or their proximity sensing module, and/or their indicator module when present. In this configuration, the assembly can optionally function as a unified controlling unit.

The embodiment of the controlling switch assembly introduces a sophisticated level of integration by allowing two or more controlling switches to share their respective set of capacitive touch areas. This shared configuration enhances efficiency by reducing redundancy in hardware components, minimizing space requirements, and promoting a more streamlined and compact design. Sharing the touch areas ensures that users can interact with the assembly as a unified interface, improving usability and maintaining a cohesive aesthetic across the system.

Additionally, in another embodiment, the assembly allows the switches to share their input module, proximity sensing module, and/or indicator module, if present. This interconnected design optimizes resource utilization by centralizing critical functions, which can significantly lower manufacturing costs and simplify installation. For example, a shared proximity sensing module enables unified detection of user presence or movement, improving the responsiveness of the entire assembly while reducing the need for duplicate sensors. Similarly, a common indicator module ensures consistent visual or sensory feedback, creating a unified user experience across all switches in the assembly.

These embodiments also provide enhanced flexibility for various applications. By allowing modular configurations where components are shared among multiple switches, the assembly can be adapted to a wide range of environments, from residential to commercial settings. This approach simplifies maintenance, as fewer components mean reduced potential for failure and easier servicing. Furthermore, by leveraging shared resources, the design promotes energy efficiency, as modules such as sensors and indicators only activate when necessary, avoiding unnecessary power consumption.

Overall, these features demonstrate a forward-thinking approach to controlling switch design, prioritizing functionality, efficiency, and adaptability while maintaining a high level of user convenience and interaction quality.

### Brief description of the Drawings

Exemplary embodiments of the invention are described using the figures. It is to be understood that these figures merely serve as examples of how the invention can be implemented and are in no way intended to be construed as limiting for the scope of the invention and the claims.
Figure 1 is a front view of the controlling switch mounted on a wall according to an embodiment of the invention;
Figure 2 presents the same perspective as Figure 1, with annotations added to emphasize the technical features;
Figure 3 illustrates the operation of the controlling switch using the set of capacitive touch areas;
Figure 4 depicts a switch assembly incorporating three integrated controlling switches;
Figure 5 shows the assembly from Figure 4 in a perspective view, mounted on a wall;
Figure 6 presents the same perspective as Figure 5, with annotations of the set of capacitive touch areas to emphasize the technical features; and
Figure 7 illustrates the system implementation, showcasing the interactions between a processing unit and various modules in accordance with an embodiment of the invention.

In the drawings, the same reference numbers have been allocated to the same or analogue element.

### Detailed description of an embodiment of the invention

Other characteristics and advantages of the present invention will be derived from the non-limitative following description, and by making reference to the drawings and the examples.

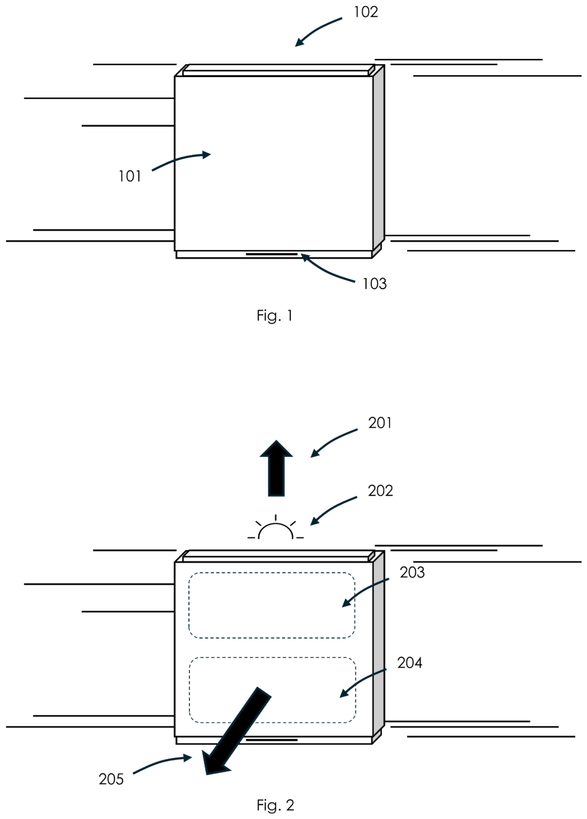

Figure 1 provides a front view of the controlling switch as mounted on a wall, illustrating its design and layout in accordance with an embodiment of the invention. This view highlights the switch's integration into the wall surface, showcasing its interface and any visible features or components that facilitate user interaction. The depiction serves to demonstrate the switch's appearance and functionality within its intended environment, emphasizing its practical and aesthetic integration into the overall system design. Figure 2 presents the same perspective as Figure 1, with annotations added to emphasize the technical features.

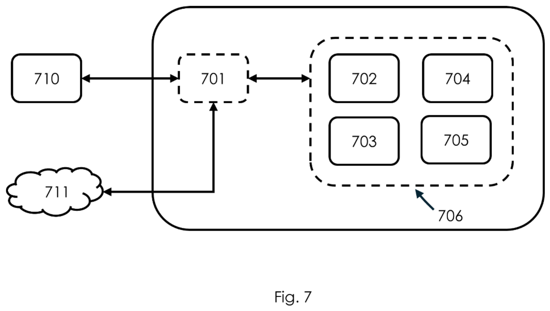

The controlling switch features a design that includes a surface panel 102, a robust housing 101, and essential interactive and signalling components. The housing incorporates a set of strategically positioned capacitive touch areas 203 and 204, enabling seamless and intuitive user interaction through touch-sensitive controls. These touch areas 203 and 204 are designed for precise detection of user input, ensuring accurate functionality while maintaining a sleek and unobtrusive aesthetic. Additionally, the switch is equipped with an indicator module 103. With reference to Figure 7, the housing comprises a set of modules 706 which are operatively connected through a processing unit 701. These modules are an input module 702, a user interface module 703, an output module 704, and a proximity sensing module 705. Additionally, it may further comprise an indicator module (not illustrated). The processing unit 701 may further be connected with a wireless connection 711 and/or an external device 710.

Figure 2 provides a detailed depiction of the various directions associated with the operation of the controlling switch. The proximity sensing module is configured to emit detection signals in direction 205, projecting outward from the wall and into the room to monitor user presence or movement. This forward-facing orientation allows the sensing module to effectively detect activity within its designated detection zone, ensuring responsive operation without unnecessary activation or missed interactions.

Simultaneously, the surface panel is illuminated in direction 201, projecting light upward 202 into the user's line of sight when they are positioned near the controlling switch. This upward illumination not only enhances visibility but also ensures that the switch's interface remains easily accessible and intuitive, even in dimly lit environments. The directed lighting provides clear feedback, signalling readiness for interaction or conveying status information, such as an active or idle state.

This thoughtful alignment of detection and illumination directions ensures seamless integration of functionality and usability. The outward projection of detection signals ensures a wide yet targeted sensing range, while the upward lighting is strategically positioned to align with ergonomic considerations, making the switch highly effective for daily use. Together, these design elements demonstrate a user-centric approach that prioritizes convenience, reliability, and efficiency in both residential and commercial settings.

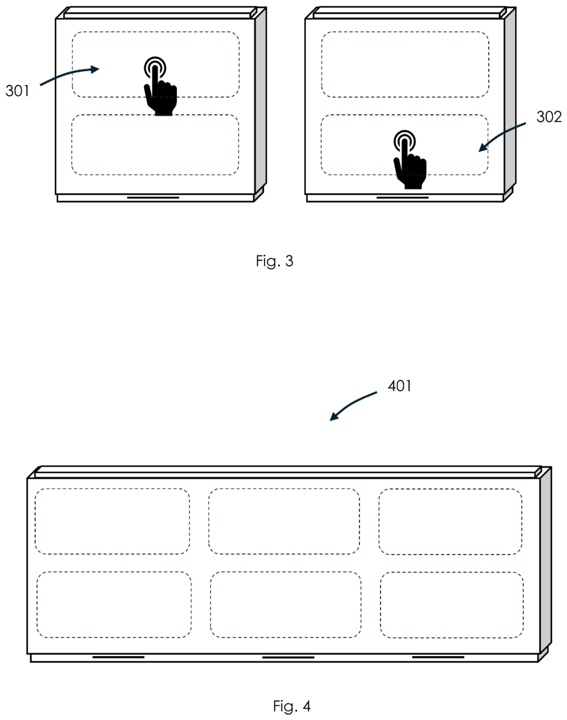

Referring to Figure 3, the operation of the controlling switch is demonstrated, showcasing how a user can interact with and control its functions. The switch is equipped with distinct touch-sensitive zones that allow intuitive and precise user input. For instance, when a user touches the upper area 302 of the surface panel, it can activate a connected light or device, effectively switching it on. Conversely, touching the lower area 301 of the panel can deactivate the light, switching it off. This straightforward interaction scheme simplifies operation and eliminates the need for complex instructions or multiple physical buttons.

Moreover, the design allows for further customization, where different touch zones can be programmed to perform additional functions, such as dimming the light, adjusting its colour temperature, or controlling other connected devices. This flexibility makes the controlling switch adaptable to various user preferences and use cases, whether in residential or commercial environments. By employing capacitive touch technology, the switch ensures a seamless and responsive experience, enhancing usability while maintaining a sleek, minimalist design. The arrangement also supports multi-user scenarios by allowing separate zones to be assigned different functions or settings, further expanding its versatility and practicality.

Figure 4 illustrates an assembly 401 comprising three controlling switches integrated into a single, unified housing. This configuration demonstrates an advanced design approach that combines multiple control points within a compact and cohesive structure. By incorporating three controlling switches into the same housing, the assembly minimizes space requirements while maintaining full functionality, making it ideal for environments where efficiency and aesthetics are paramount.

Each controlling switch within the assembly is designed to operate independently or in coordination with the others, offering enhanced flexibility for controlling multiple devices or functions from a single unit. For example, one switch could be assigned to control lighting, another to manage climate settings, and a third to operate electronic devices, all seamlessly accessible in one housing.

The shared housing also promotes a clean and organized appearance, reducing the clutter typically associated with multiple standalone switches. Additionally, this arrangement supports streamlined wiring and installation, saving time and resources during setup. The integrated design ensures a consistent user experience across all switches, while the modular nature of the assembly allows for scalability and customization to suit specific user needs or environmental requirements. This innovative approach exemplifies the adaptability and sophistication of modern controlling switch systems.

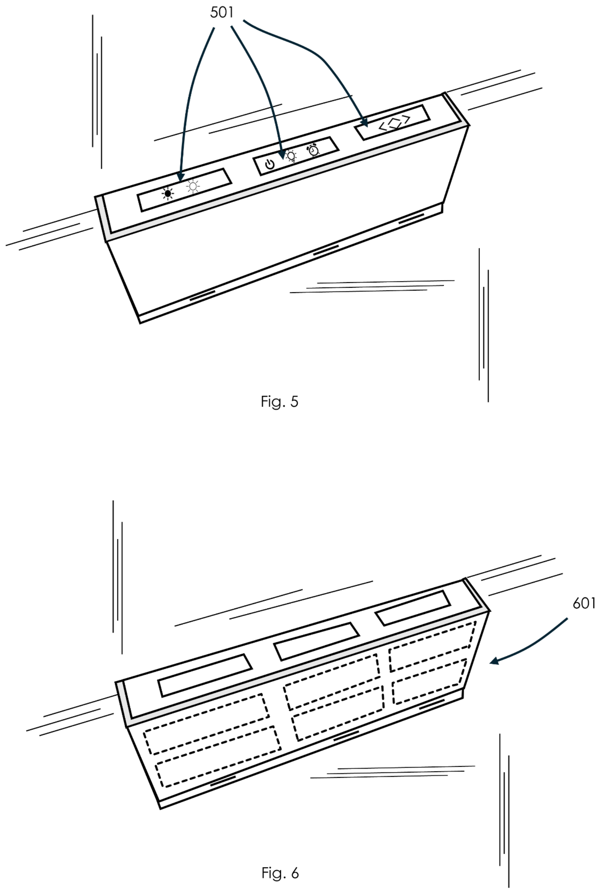

The same assembly is further depicted in Figure 5, where it is shown mounted on a wall, featuring three distinct surface panels 501 designed for user interaction. Each surface panel is equipped with input areas that allow users to control various functions with ease. The wall-mounted configuration highlights the assembly's adaptability for practical installation in residential or commercial settings, where its sleek design integrates seamlessly into the surrounding environment.

Figure 6 builds on this outline by illustrating the set of capacitive touch areas 601 embedded within the surface panels. These touch-sensitive zones provide precise and responsive input capabilities, enabling intuitive operation for users. The arrangement of the touch areas can be customized to support specific control schemes, such as activating individual devices, adjusting settings, or toggling between different modes.

Together, these illustrations emphasize the assembly's modular and user-centric design. The combination of surface panels and touch areas allows for an optimized balance between functionality and aesthetics, while the wall-mounted configuration underscores the system's space-saving and elegant integration. These features make the assembly a versatile solution for a wide range of applications, offering a modern and intuitive interface for controlling connected systems.

### CLAUSES

First clause: A controlling switch configured to be installed within an enclosure of a vertical wall surface of a residential electrical installation for controlling a state of an electrical circuit thereof, the controlling switch comprising a housing enclosing operatively coupled modules through a processing unit comprising:
- an input module 702 configured to receive electrical power from an external power source;
- a user interface module 703 comprising:
   ∘ a surface panel 102 comprising a light-emitting assembly configured to illuminate 202 at least a portion of the surface panel for displaying input information;
   ∘ a set of capacitive touch areas 203, 204 configured to receive an input command 301, 302 related to the input information;
- an output module 704 configured to control the state of the electrical circuit based on the input command;
- a proximity sensing module 705 configured to emit detection signals and receive reflected signals for detecting a presence of a user;
wherein the surface panel 102 and the proximity sensing module (705) are positioned in different planes of the housing such that the detection signals are emitted according to a first direction 205, and the light-emitting assembly emits light (202) according to a second direction 201 different from the first direction (205).

Second clause: The controlling switch according to the first clause, wherein the set of capacitive touch areas (203, 204) are positioned according to the first direction 205.

Third clause: The controlling switch according to any of the preceding clauses, wherein the set of capacitive touch areas 203, 204 is incorporated into the proximity sensing module 705.

Fourth clause: The controlling switch according to any of the preceding clauses, wherein when mounted within the enclosure, the first direction 205 comprises a first spatial direction substantially perpendicular to and away from the wall surface, and the second direction 201 comprises a second spatial direction substantially parallel to and upwards along the wall surface.

Fifth clause: The controlling switch according to any of the preceding clauses, further comprising an indicator module 103 comprising indicator means configured to signal the presence of a user, the indicator module 103 positioned at the front plane when mounted within the enclosure.

Sixth clause: The controlling switch according to any of the preceding clauses, wherein the processing unit 701 is configured to analyse received reflected signals, and determine therefrom a condition comprising a presence, distance, and/or movement of a user based on variations in the reflected signals, and to instruct the user interface module 703 to illuminate 202 the surface panel based on the condition.

Seventh clause: The controlling switch according to the sixth clause when dependent on the fifth clause, wherein the processing unit 701 is further configured to instruct the indicator module 103 to signal the presence of a user based on the condition.

Eight clause: The controlling switch according to the seventh clause, wherein the processing unit 701 is further configured to first instruct the indicator module 103 to signal the presence of a user prior to instruct the user interface module 703 to illuminate 202 the surface panel 102 based on the condition during a predefined time interval.

Nineth clause: The controlling switch according to any of the preceding clauses, wherein the set of capacitive touch areas 203, 204 is further configured to detect a user's touch input 301, 302 comprising a location, a duration, and/or intensity, and wherein the input command comprises the user's touch input.

Tenth clause: The controlling switch according to any of the preceding clauses, wherein the proximity sensing module 705 comprises an infrared emitter and detector for detecting the presence of a user based on reflected infrared light.

Eleventh clause: The controlling switch according to any of the clauses one to nine, wherein the sensing module 705 comprises an ultrasonic transducer configured to detect objects based on sound wave reflections.

Twelfth clause: The controlling switch according to any of the preceding clauses, wherein the external power source comprises a power source associated with the electrical circuit.

Thirteenth clause: The controlling switch according to any of the preceding clauses, wherein the output module 704 is further configured to switch the state of the electrical circuit into a closed and opened position.

Fourteenth clause: The controlling switch according to any of the preceding clauses, wherein the output module 702 is further configured to selectively adjust at least one characteristic of electrical current flowing in the electrical circuit when active, the characteristic comprising a voltage, current intensity, frequency, and/or waveform shape.

Fifteenth clause: The controlling switch according to any of the preceding clauses, wherein the output module 702 comprises a wireless communication module 711 configured to control the state of a connected device 710 based on the input command.

Sixteenth clause: The controlling switch according to any of the preceding clauses, wherein the surface panel 102 is further configured to visually represent the state of the electrical circuit.

Seventeenth clause: The controlling switch according to any of the preceding clauses, wherein the housing comprises a decorative cover to protect the proximity sensing module 705 while maintaining signal transmission efficiency.

Eighteenth clause: A controlling switch assembly 401 comprising a housing comprising two or more controlling switches according to any of the preceding clauses.

Nineteenth clause: The controlling switch assembly 401 according to the eighteenth clause, wherein the two or more controlling switches are configured to share their respective set of capacitive touch areas.

Twentieth clause: The controlling switch assembly 401 according to nineteenth clause, wherein the two or more controlling switches are further configured to share their input module, and/or their proximity sensing module, and/or their indicator module when present.

It should be understood that the present invention is not limited to the described embodiments and that variations can be applied without going outside of the scope of the claims.

## Claims

1. A controlling switch configured to be installed within an enclosure of a vertical wall surface of a residential electrical installation for controlling a state of an electrical circuit thereof, the controlling switch comprising a housing enclosing operatively coupled modules through a processing unit comprising:
- an input module (702) configured to receive electrical power from an external power source;
- a user interface module (703) comprising:
∘ a surface panel (102) comprising a light-emitting assembly configured to illuminate (202) at least a portion of the surface panel for displaying input information;
∘ a set of capacitive touch areas (203, 204) configured to receive an input command (301, 302) related to the input information;
- an output module (704) configured to control the state of the electrical circuit based on the input command;
- a proximity sensing module (705) configured to emit detection signals and receive reflected signals for detecting a presence of a user;
wherein the surface panel (102) and the proximity sensing module (705) are positioned in different planes of the housing such that the detection signals are emitted according to a first direction (205), and the light-emitting assembly emits light (202) according to a second direction (201) different from the first direction (205).

2. The controlling switch according to claim 1, wherein the set of capacitive touch areas (203, 204) are positioned according to the first direction (205).

3. The controlling switch according to any of the preceding claims, wherein when mounted within the enclosure, the first direction (205) comprises a first spatial direction substantially perpendicular to and away from the wall surface, and the second direction (201) comprises a second spatial direction substantially parallel to and upwards along the wall surface.

4. The controlling switch according to any of the preceding claims, further comprising an indicator module (103) comprising indicator means configured to signal the presence of a user, the indicator module (103) positioned at the front plane when mounted within the enclosure.

5. The controlling switch according to any of the preceding claims, wherein the processing unit (701) is configured to analyse received reflected signals, and determine therefrom a condition comprising a presence, distance, and/or movement of a user based on variations in the reflected signals, and to instruct the user interface module (703) to illuminate (202) the surface panel based on the condition.

6. The controlling switch according to any of the preceding claims, wherein the set of capacitive touch areas (203, 204) is further configured to detect a user's touch input (301, 302) comprising a location, a duration, and/or intensity, and wherein the input command comprises the user's touch input.

7. The controlling switch according to any of the preceding claims, wherein the proximity sensing module (705) comprises an infrared emitter and detector for detecting the presence of a user based on reflected infrared light.

8. The controlling switch according to any of the preceding claims, wherein the external power source comprises a power source associated with the electrical circuit.

9. The controlling switch according to any of the preceding claims, wherein the output module (704) is further configured to switch the state of the electrical circuit into a closed and opened position.

10. The controlling switch according to any of the preceding claims, wherein the output module (702) is further configured to selectively adjust at least one characteristic of electrical current flowing in the electrical circuit when active, the characteristic comprising a voltage, current intensity, frequency, and/or waveform shape.

11. The controlling switch according to any of the preceding claims, wherein the output module (702) comprises a wireless communication module (711) configured to control the state of a connected device (710) based on the input command.

12. The controlling switch according to any of the preceding claims, wherein the surface panel (102) is further configured to visually represent the state of the electrical circuit.

13. A controlling switch assembly (401) comprising a housing comprising two or more controlling switches according to any of the preceding claims.

14. The controlling switch assembly (401) according to claim 13, wherein the two or more controlling switches are configured to share their respective set of capacitive touch areas.

15. The controlling switch assembly (401) according to claim 14, wherein the two or more controlling switches are further configured to share their input module, and/or their proximity sensing module, and/or their indicator module when present.
